# EUROPEAN PATENT APPLICATION

(11) **EP 2 237 512 A1**
(43) Date of publication of application: **06.10.2010**
(21) Application number: 08870947.2
(22) Date of filing: 25.12.2008
(51) Int. Cl.: H04L 25/49

(54) **METHOD AND APPARATUS, TRANSMITTER AND TRANSMITTING METHOD OF DETERMINING OPEN LOOP PRE-DISTORTION PARAMETER**

(30) Priority: 27.12.2007 CN 200710305670; 30.06.2008 CN 200810128211
(71) Applicant: Huawei Technologies Co., Ltd., Longgang District, Shenzhen Guangdong 518129 (CN)
(72) Inventor: DENG, Jiefeng, Guangdong 518129 (CN); SHEN, Tao, Guangdong 518129 (CN)
(74) Representative: Pfenning, Meinig & Partner GbR
(86) International application number: PCT/CN2008/073736
(87) International publication number: WO 2009/089731

(57) **Abstract**

The present invention provides a method and an apparatus for determining open loop predistortion parameters, a transmitter, and a transmitting method to improve linearity of the transmitter and reduce the operation cost and manufacturing cost. The method for determining the open loop predistortion parameters includes: selecting open loop predistortion parameters in an open loop predistortion parameter database as candidate open loop predistortion parameters of a transmitter; and using a training signal to determine the candidate open loop predistortion parameters of the transmitter if none of feedback signals corresponding to all open loop predistortion parameters in the open loop predistortion parameter database satisfies Radio Frequency (RF) requirements. According to the present invention, an open loop predistortion technology is applied to improve linearity of the transmitter, thus reducing the regression of a High Power Amplifier (HPA), improving the working efficiency, and reducing the operation cost. Moreover, no feedback channel or parameter correction calculation on the processor is required. Therefore, the manufacturing cost is reduced.

## Description

This application claims priority to Chinese Patent Application No. 200710305670.4, filed with the Chinese Patent Office on December 27, 2007, and Chinese Patent Application No. 200810128211.8, filed with the Chinese Patent Office on June 30, 2008, both entitled "Method and Apparatus for Determining Open Loop Predistortion Parameters, Transmitter and Transmitting Method", which are incorporated herein by reference in their entirety.

### Field of the Invention

The present invention relates to a communications technology, and in particular, to a method and an apparatus for determining open loop predistortion parameters, a transmitter, and a transmitting method.

### Background of the Invention

In a radio transmitter, a primary contradiction is the contradiction between the efficiency of a High Power Amplifier (HPA) and the linearity of the HPA. With the popularity of data services, the requirement on the spectrum utilization is higher and higher, and the non-constant envelopes modulation mode is applied widely. The non-linearity of the HPA lowers the quality of transmitted non-constant envelope signal modulation, and generates interference to the user signal on neighboring channels. In a modem radio communication system, the technology for improving transmitter linearity is a focus of competition between manufacturers. The non-constant envelopes digital modulation mode imposes high requirements on the linearity indicator and the power indicator of a transmitter. In the prior art, the following methods are available for improving the linearity of a transmitter:
(1) Power back off: The output power is reduced so that the HPA works in a linear area. The defects of this method are low efficiency of the HPA and high cost of operation.
(2) Feedforward: The analog circuits in use are complicated. In the manufacturing process, the modules need to be adjusted one by one, which leads to low consistency of the manufacturing process and makes little improvement for the efficiency of the HPA.
(3) Predistortion: An additional feedback channel is required. The processor keeps updating the algorithm parameters, thus increasing the manufacturing cost and calculation complexity.

In conclusion, the prior art for improving the linearity of the transmitter is characterized by high operation cost or manufacturing cost.

### Summary of the Invention

Embodiments of the present invention provide a method and an apparatus for determining open loop predistortion parameters, a transmitter, and a transmitting method to improve linearity of the transmitter and reduce the operation cost and manufacturing cost.

In one aspect, the present invention provides a method for determining open loop predistortion parameters, which includes:
selecting open loop predistortion parameters in an open loop predistortion parameter database as candidate open loop predistortion parameters of a transmitter; and
using a training signal to determine candidate open loop predistortion parameters of the transmitter if none of feedback signals corresponding to all open loop predistortion parameters in the open loop predistortion parameter database satisfies Radio Frequency (RF) requirements.

In one aspect, the present invention provides an apparatus for obtaining open loop predistortion parameters, which includes:
an open loop predistortion parameter database, configured to store open loop predistortion parameters;
a first judging unit, configured to: judge whether none of feedback signals corresponding to all open loop predistortion parameters in the open loop predistortion parameter database satisfies RF requirements, and start a second determining unit if none of the feedback signals satisfies the RF requirements, or start a first determining unit if any of the feedback signals satisfies the RF requirements;
the first determining unit, configured to determine candidate open loop predistortion parameters of a transmitter according to the open loop predistortion parameters in the open loop predistortion parameter database; and
the second determining unit, configured to determine candidate open loop predistortion parameters of the transmitter by using a training signal.

In one aspect, the present invention provides a transmitter, which includes:
a predistorter, configured to: receive a baseband signal from a baseband modulator, pre-distort the baseband signal by using open loop predistortion parameters, and send the pre-distorted signal to a downstream component, where the open loop predistortion parameters are pre-set in the predistorter.

In one aspect, the present invention provides a transmitting method, which includes:
receiving a baseband signal output by a baseband modulator; and
pre-distorting the baseband signal by using open loop predistortion parameters, and sending the pre-distorted signal to a downstream component, where the open loop predistortion parameters are preset in a predistorter.

In the embodiments of the present invention, an open loop predistortion technology is applied to improve linearity of the transmitter, thus reducing the power back off of the HPA, improving the working efficiency, and reducing the operation cost. Moreover, no feedback channel or parameter correction calculation on the processor is required, and the embodiments of the present invention reduce the manufacturing cost.

### Brief Description of the Drawings

FIG. 1 shows a transmitter in Embodiment 1 of the present invention;
FIG. 2 shows a transmitter in Embodiment 2 of the present invention;
FIG. 3 is a flowchart of a transmitting method provided in Embodiment 3 of the present invention;
FIG. 4 shows a process of training and obtaining open loop predistortion parameters in Embodiment 4 of the present invention;
FIG. 5 shows a process of training and obtaining open loop predistortion parameters in iterative mode in Embodiment 5 of the present invention;
FIG. 6 shows a process of obtaining open loop predistortion parameters from an open loop predistortion parameter database in Embodiment 6 of the present invention;
FIG 7 shows a process of calculating open loop predistortion parameters in Embodiment 7 of the present invention;
FIG. 8 shows an apparatus for obtaining open loop predistortion parameters in Embodiment 8 of the present invention; and
FIG. 9 shows a structure of a first feedback IQ signal obtaining unit or a second feedback IQ signal obtaining unit in Embodiment 8 of the present invention.

### Detailed Description of the Embodiments

To make the present invention clearer to those skilled in the art, the following describes the embodiments of the present invention in more detail with reference to the accompanying drawings.

In the embodiments of the present invention, open loop predistortion parameters are used to pre-distort a signal output by a baseband modulator (which is hereinafter referred to as "open loop predistortion technology"), and the pre-distorted signal is sent to the downstream component for processing. The open loop predistortion parameters are obtained through training beforehand. In this way, the linearity of the transmitter is improved, the power back off of the HPA is reduced, the working efficiency is improved, and the operation cost is reduced. Moreover, no feedback channel or parameter correction calculation on the processor is required. Therefore, the embodiments of the present invention reduce the manufacturing cost and the processor overhead. The transmitter and the transmitting method under the present invention are detailed below with reference to exemplary embodiments. Embodiment 1 and Embodiment 2 below describe two types of transmitter respectively; Embodiment 3 describes a transmitting method; Embodiment 4, Embodiment 5, and Embodiment 6 describe a process of obtaining open loop predistortion parameters respectively; Embodiment 7 describes a process of calculating open loop predistortion parameters; and Embodiment 8 describes an apparatus for obtaining open loop predistortion parameters.

### Embodiment 1

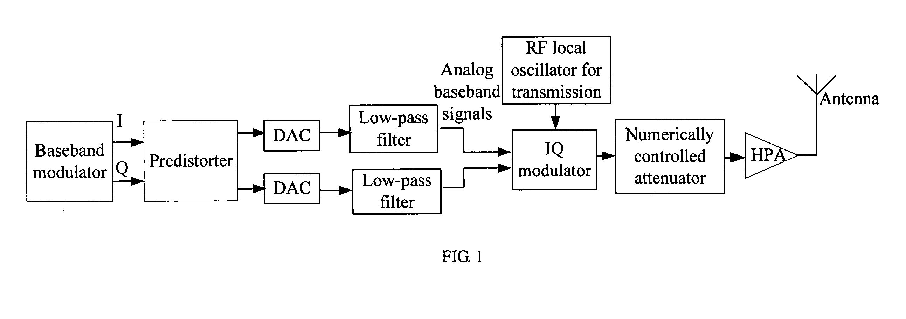

As shown in FIG. 1, Embodiment 1 describes a scenario in which an open loop predistortion technology is applied to a zero Intermediate Frequency (IF) transmitter. The transmitter includes:
a baseband modulator, configured to output a baseband signal to a predistorter;
the predistorter, configured to: receive the baseband signal output by the baseband modulator, use open loop predistortion parameters to pre-distort the baseband signal, and send the pre-distorted signal to a Digital Analog Converter (DAC), where the open loop predistortion parameters are preset in the predistorter (the method for obtaining the open loop predistortion parameters is detailed in Embodiment 4, Embodiment 5, or Embodiment 6), the predistorter may use a Field Programmable Gate Array (FPGA) or Application Specific Integrated Circuits (ASIC) to process the baseband signal in real time, and, even for a low-rate signal such as Global System for Mobile communications (GSM) signal, the predistorter may use a Digital Signal Processor (DSP) or another type of processor to process the baseband signal in real time;
the DAC, configured to convert the pre-distorted signal into an analog zero IF signal;
a low-pass filter, configured to perform low-pass filtering for the analog zero IF signal output by the DAC to obtain an analog baseband signal;
an Inphase and Quadrature (IQ) modulator, configured to convert the analog baseband signal into an RF signal directly through Analog Quadrature Modulation (AQM);
a numerically controlled attenuator, configured to: perform amplification, attenuation, and impedance matching for the RF signal (that is, a small signal) that pass through an RF channel to obtain a signal available for an HPA, and then output the signal to the HPA; and
the HPA, configured to amplify power of the signal output by the numerically controlled attenuator, whereupon the signal is sent out by antennas.

### Embodiment 2

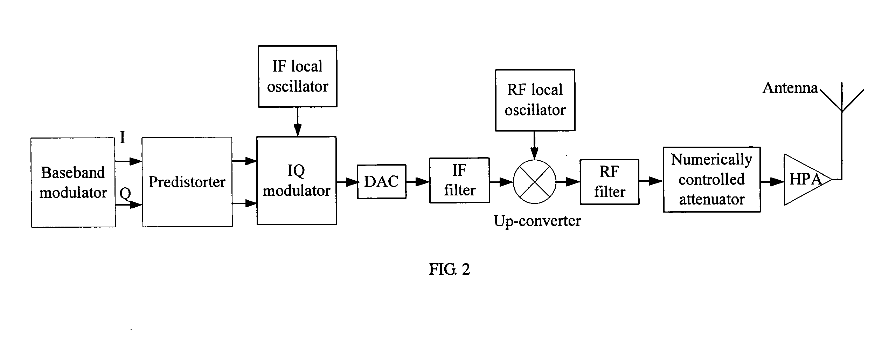

As shown in FIG. 2, Embodiment 2 describes a scenario in which an open loop predistortion technology is applied to a digital IF transmitter. The transmitter includes:
a baseband modulator, configured to output a baseband signal to a predistorter;
the predistorter, configured to: receive the baseband signal output by the baseband modulator, use open loop predistortion parameters to pre-distort the baseband signal, and send the pre-distorted signal to an IQ modulator, where the open loop predistortion parameters are obtained through training beforehand (the method for obtaining the open loop predistortion parameters is detailed in Embodiment 4, Embodiment 5, or Embodiment 6), the predistorter may use an FPGA or ASIC to process the baseband signal in real time, and, even for a low-rate signal such as GSM signal, the predistorter may use a DSP or another type of processor to process the baseband signal in real time;
the IQ modulator, configured to modulate the pre-distorted signal to an IF signal;
a DAC, configured to convert the IF signal into an analog IF signal;
an IF filter, configured to perform IF filtering for the analog IF signal;
an up-converter, configured to up-convert the signal output by the IF filter into an RF signal;
an RF filter, configured to filter the RF signal;
a numerically controlled attenuator, configured to: attenuate the signal output by the RF filter, and output the attenuated signal to an HPA; and
the HPA, configured to amplify power of the signal output by the numerically controlled attenuator, whereupon the signal is sent out by antennas.

### Embodiment 3

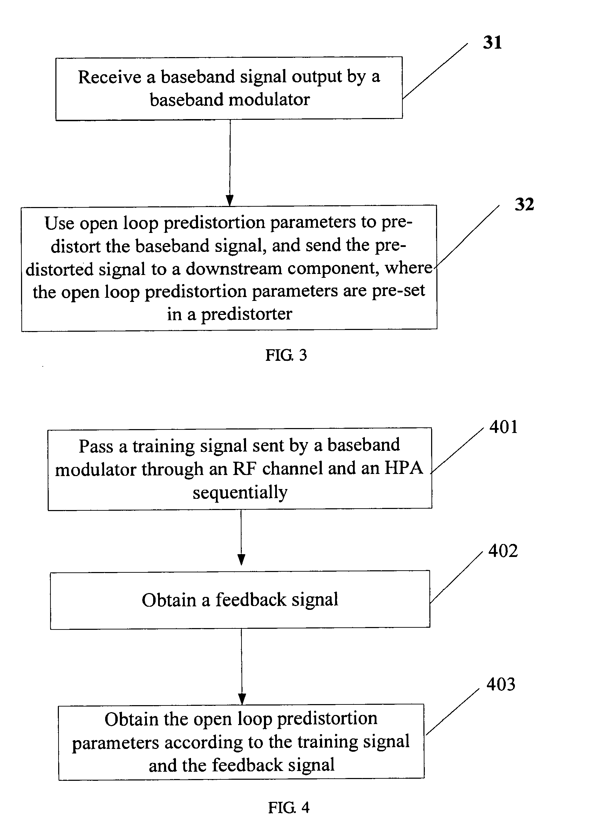

As shown in FIG 3, a transmitting method provided in this embodiment includes the following steps:
Step 31: Receive a baseband signal output by a baseband modulator.
Step 32: Use open loop predistortion parameters to pre-distort the baseband signal, and send the pre-distorted signal to a downstream component, where the open loop predistortion parameters are preset in a predistorter.

The open loop predistortion parameters may be determined in this way: Determine open loop predistortion parameters of the transmitter by using the open loop predistortion parameters in an open loop predistortion parameter database (see Embodiment 6); or determine the open loop predistortion parameters of the transmitter by using a training signal if none of feedback signals corresponding to all the open loop predistortion parameters in the open loop predistortion parameter database satisfies RF requirements (see Embodiment 4 or Embodiment 5).

### Embodiment 4

This embodiment describes a method for obtaining open loop predistortion parameters, and in particular, a method for obtaining open loop predistortion parameters through training. As shown in FIG 4, the method for obtaining open loop predistortion parameters includes the following steps:
Step 401: Pass the training signal sent by a baseband modulator through an RF channel and an HPA sequentially. If the predistorter is not removed from the transmitter, the training signal sent from the baseband modulator need to pass through the RF channel and the HPA sequentially after passing through the predistorter. In this case, the signal may pass through the predistorter without distortion by stopping real-time correction in the predistorter or setting the predistortion parameters in the predistorter as bypass parameters. After passing through the RF channel (based on a zero IF solution, or a digital IF solution), the signal is amplified by an HPA.
Step 402: Obtain a feedback signal. That is, the RF signal output by the HPA is attenuated, and the attenuated signal (also called feedback signal) is divided into two channels: one channel for RF requirement test and the other channel for data collecting.

The data collection may be performed in any one of the following ways:
(1) The RF signal is connected to a spectrum analyzer, and the spectrum analyzer demodulates the RF signal into a baseband digital signal; or
(2) The RF signal is down converted, and then sampled through an Analog Digital Converter (ADC). Then, the sampled signal is demodulated into a baseband digital signal.

Step 403: Calculate the open loop predistortion parameters according to the training signal and the feedback signal to obtain the open loop predistortion parameters. (The method for calculating the open loop predistortion parameters is detailed in Embodiment 7.)

The calculated open loop predistortion parameters are determined as candidate open loop predistortion parameters of the transmitter.. (The candidate open loop predistortion parameters are the open loop predistortion parameters that are available to the corresponding transmitter and have passed the RF requirement test. There may be one or more candidate open loop predistortion parameters).

The following test step may be performed before the calculated open loop predistortion parameters are determined as candidate open loop predistortion parameters of the transmitter:

Use the obtained open loop predistortion parameters as test open loop predistortion parameters, download the parameters to the predistorter, and recover the real-time correction in the predistorter. Through the RF requirement test, judge whether the correction result of open loop predistortion satisfies requirements, namely, whether the feedback signal satisfies RF requirements; if the feedback signal satisfies the RF requirements, terminate the training process, and use the test open loop predistortion parameters as candidate open loop predistortion parameters of the transmitter; if the feedback signal does not satisfy the RF requirements, use an iterative mode to continue calculating open loop predistortion parameters (see Embodiment 5). The RF requirements may be requirements specified in the protocol (for example, ACLR specifications in WCDMA; EVM, modulation spectrum, and switch spectrum specifications in GSM). For example, when the power of the Enhanced Data Rate for GSM Evolution (EDGE) signal output by a 900 MHz GSM macro base station is greater than or equal to 20 watts, the modulation spectrum indicator at 400 KHz is required to be less than -56 dB or another index specified by a system designer.

### Embodiment 5

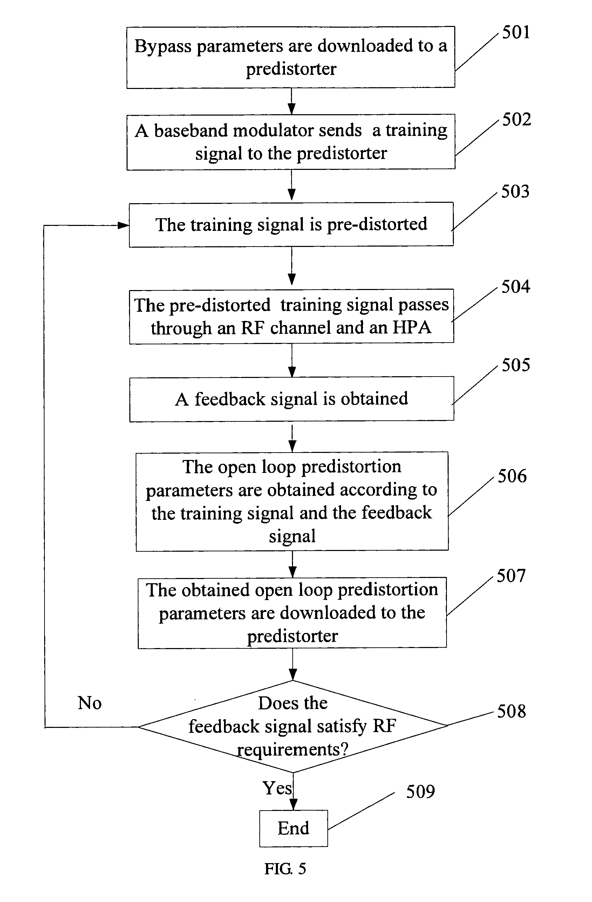

An iterative mode may be applied to obtain desired open loop predistortion parameters. As shown in FIG 5, a method for obtaining open loop predistortion parameters in iterative mode includes the following steps:
Step 501: Open loop predistortion parameters of a predistorter are set as bypass parameters. That is, the bypass parameters are downloaded to the predistorter as test predistortion parameters.
Step 502: A baseband modulator sends a training signal (IQ signal) to the predistorter.
Step 503: The training signal is pre-distorted according to the open loop predistortion parameters of the predistorter.
Step 504: The pre-distorted training signal pass through an RF channel (based on a zero IF solution or a digital IF solution), and are then amplified by an HPA.
Steps 501-503 above may be implemented simply by removing the predistorter or by stopping real-time correction function of the predistorter.
Step 505: an RF signal output by the HPA are attenuated into a feedback signal. The feedback signal is divided into two channels: one channel for RF requirement test and the other channel for data collecting. The method for data collection is similar as that mentioned in step 402.
Step 506: Open loop predistortion parameters are calculated according to the training signal and the feedback signal to obtain open loop predistortion parameters as test open loop predistortion parameters (the calculation method is described in Embodiment 7).
Step 507: The calculated open loop predistortion parameters (namely, test open loop predistortion parameters) are downloaded to the predistorter.
Step 508: A judgment is made about whether a feedback signal corresponding to the test open loop predistortion parameters satisfies the RF requirements. If the feedback signal satisfies the RF requirements, the process proceeds to step 509; if the feedback signal does not satisfy the RF requirements, steps 503-508 are repeated until the feedback signal satisfies the RF requirements.
Step 509: The training process is terminated, and the test open loop predistortion parameters are determined as candidate open loop predistortion parameters of the transmitter.

### Embodiment 6

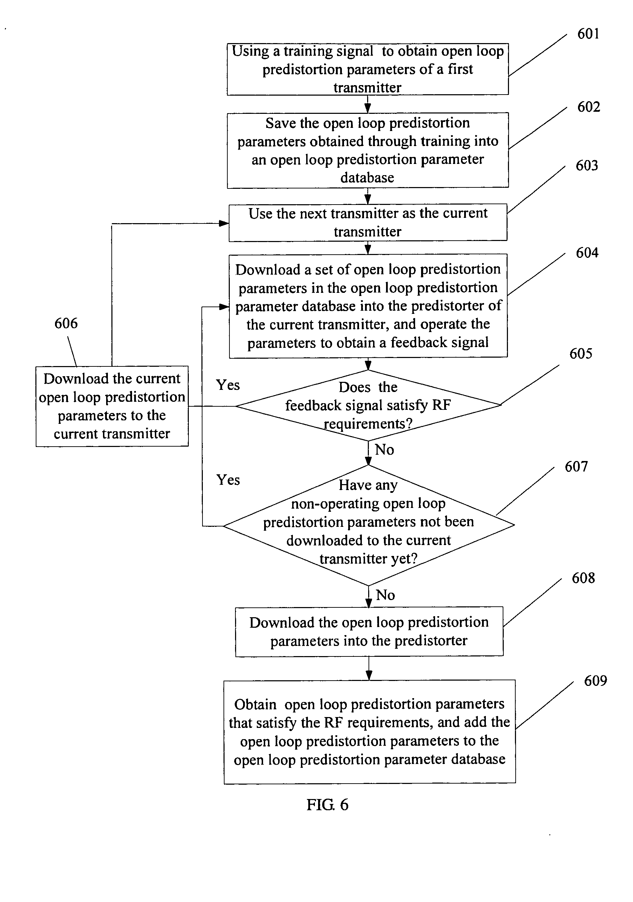

Embodiment 4 and Embodiment 5 describe the process of obtaining open loop predistortion parameters through training for a transmitter. The baseband unit, predistorter, transmitting channel (that is, RF channel), and HPA described in Embodiment 4 and Embodiment 5 may be components of a tested transmitter. In the manufacturing process, if every transmitter is trained for open loop predistortion parameters, it takes too much time. As shown in FIG. 6, the open loop predistortion parameters may be obtained in the following way to shorten the time of obtaining the open loop predistortion parameters: select open loop predistortion parameters in the open loop predistortion parameter database as candidate open loop predistortion parameters of the transmitter; or use a training signal to determine candidate open loop predistortion parameters of the transmitter if none of feedback signals corresponding to all open loop predistortion parameters in the open loop predistortion parameter database satisfies RF requirements. The detailed process is as follows:
Step 601: Using a training signal for open loop predistortion parameters of a first transmitter in the way described in Embodiment 4 and Embodiment 5.
Step 602: Save the open loop predistortion parameters obtained through training into an open loop predistortion parameter database.
Step 603: Use the next transmitter as the current transmitter so as to obtain candidate open loop predistortion parameters of the next transmitter.
Step 604: Download a set of open loop predistortion parameters in the open loop predistortion parameter database into the predistorter of the current transmitter directly so as to obtain a feedback signal. Record the feedback signal and the set of open loop predistortion parameters. The method for obtaining the feedback signal is detailed in Embodiment 4 or Embodiment 5.
Step 605: Judge whether the feedback signal satisfies RF requirements. Proceed to step 606 if the feedback signal satisfies the RF requirements; go to step 607 if the feedback signal does not satisfy the RF requirements.
Step 606: Obtain available open loop predistortion parameters without training, and download the available open loop predistortion parameters to the predistorter of the current transmitter as candidate open loop predistortion parameters. Then, return to step 603 to train the next transmitter for open loop predistortion parameters.
Step 607: Judge whether any other set of open loop predistortion parameters in the open loop predistortion parameter database are still not downloaded to the predistorter of the current transmitter for operation. If any other set of open loop predistortion parameters are still not downloaded, return to step 604; proceed to step 608 if all other sets of open loop predistortion parameters are downloaded.
Step 608: Select any set of open loop predistortion parameters randomly, and download the set of open loop predistortion parameters into the predistorter.

In this embodiment, the open loop predistortion parameters with the preferred RF requirements may be downloaded as candidate open loop predistortion parameters downloaded into the predistorter.

This step may be skipped, and the process goes to step 609.

Step 609: Optionally, obtain open loop predistortion parameters where a feedback signal corresponding to the open loop predistortion parameters satisfies the RF requirements in the way described in Embodiment 5 (except that the bypass parameters in step 501 in Embodiment 5 are replaced with the open loop predistortion parameters selected randomly in step 608), and add the obtained open loop predistortion parameters to the open loop predistortion parameter database where a feedback signal corresponding to the open loop predistortion parameters satisfies the RF requirements.

If step 608 is skipped, open loop predistortion parameters may be obtained in the way described in Embodiment 4, or open loop predistortion parameters where a feedback signal corresponding to the open loop predistortion parameters satisfies the RF requirements are obtained in the way described in Embodiment 5.

In step 605, if the feedback signal satisfies the RF requirements, the following additional steps may be performed before step 606: Record the set of open loop predistortion parameters, and the RF requirements corresponding to the set of open loop predistortion parameters; continue traversing the open loop predistortion parameter database, and record the open loop predistortion parameters when the feedback signal satisfies the RF requirements, and the RF requirements corresponding to the open loop predistortion parameters; finally, search for the open loop predistortion parameters with the preferred RF requirements among the recorded open loop predistortion parameters and the RF requirements corresponding to the recorded open loop predistortion parameters, and use such open loop predistortion parameters as candidate open loop predistortion parameters of the transmitter, and then proceed to step 606.

In the process of manufacturing the transmitter, the open loop predistortion parameters saved in the open loop predistortion parameter database keep increasing, and the time spent in finding the proper open loop predistortion parameters among the saved parameters increases accordingly. The following steps may be performed to optimize the open loop predistortion parameter database.

Add a new set of open loop predistortion parameters obtained through training (the weight is set to an initial value) to the open loop predistortion parameter database directly if the number of sets of open loop predistortion parameters in the open loop predistortion parameter database do not exceed the threshold (for example, the database can store a maximum of 20 sets of open loop predistortion parameters, but actually stores only 3 sets of open loop predistortion parameters).

Test the correction results of the open loop predistortion parameters in the open loop predistortion parameter database for the untrained transmitter.

Increase the weight for the open loop predistortion parameters whose RF requirements satisfy the requirements.

Add a new set of open loop predistortion parameters to the open loop predistortion parameter database if the number of sets of open loop predistortion parameters in the open loop predistortion parameter database does not exceed the threshold. Substitute the new set of open loop predistortion parameters for the open loop predistortion parameters of the lowest weight in the database if the number of sets of open loop predistortion parameters exceeds the threshold.

### Embodiment 7

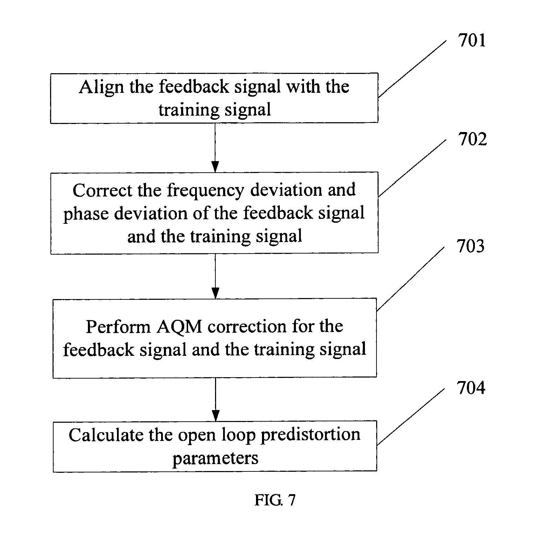

As shown in FIG 7, a method for calculating the open loop predistortion parameters in this embodiment includes the following steps:
Step 701: Align the feedback signal with the training signal (namely, the baseband signal).

A fixed delay exists while the training signal passes through the predistorter, RF channel, and HPA. To obtain correct open loop predistortion parameters, the training signal (hereinafter referred to as "the baseband signal") need to be aligned with the demodulation signal after data collection (hereinafter referred to as "feedback signal"). The alignment method is as follows:
(1) Perform relevant calculation for the baseband signal and the feedback signal.
(2) Find the position of the relevant peak in the relevant calculation results, and obtain the delay between the baseband signal and the feedback signal.
(3) Align the baseband signal with the feedback signal with respect to time according to the delay.

The sampling rate of the feedback signal is definite, but the delay is not necessarily an integral multiple of the minimum sampling period. For example, when the sampling rate is 10 MHz, the minimum sampling period is 0.1 ns. When the delay is 6.12 ns, only 6.1 ns (namely, an integral multiple of the minimum sampling period) can be compensated according to the relevant calculation, and a remaining 0.02 ns delay is not compensated correctly yet. In this case, the precision of delay compensation may be improved through increase of the sampling rate so that correction parameters are calculated more accurately. However, after the sampling rate is increased, the amount of relevant calculation increases greatly. The following optional process may be performed to improve calculation efficiency:
(1) Reduce the sampling rate of the baseband signal and the feedback signal, and perform relevant calculation at a low sampling rate.
(2) Obtain a rough delay value according to the position of the relevant peak, and align the baseband signal and the feedback signal roughly.

After the rough alignment, the delay error is controlled within the range of double low sampling rate periods.
(3) Perform relevant calculation at a high sampling rate within the range of two low sampling rate periods for the baseband signal and feedback signal after the rough alignment.
(4) Obtain a precise delay value according to the positions of the relevant peaks, and align the baseband signal and the feedback signal precisely.

Step 702: Correct the frequency deviation and phase deviation of the feedback signal and the training signal.

Frequency deviation and phase deviation may occur after the baseband signal pass through the RF channel and the HPA. Therefore, it is necessary to correct the frequency deviation and phase deviation of the feedback signal and the training signal.

Step 703: Perform AQM correction for the feedback signal and training signal.

The IQ modulator incurs gain imbalance, phase imbalance and direct current bias inherently due to features of analog components. AQM correction may be performed to make predistortion parameter calculation more accurate. If the requirement is not strict, only the direct current bias may need to be compensated.

If a digital IQ modulator is applied, this step may be skipped, and the process skips to step 704.

Step 704: Calculate open loop predistortion parameters according to the training signal and feedback signal obtained after steps 701 to 702(or 703).

The open loop predistortion parameters may be calculated based on any one of many models such as the Volterra series model, Hammerstein model, and Polynomial model. In an open loop digital predistortion system, the open loop predistortion parameters may be calculated through any appropriate method.

### Embodiment 8

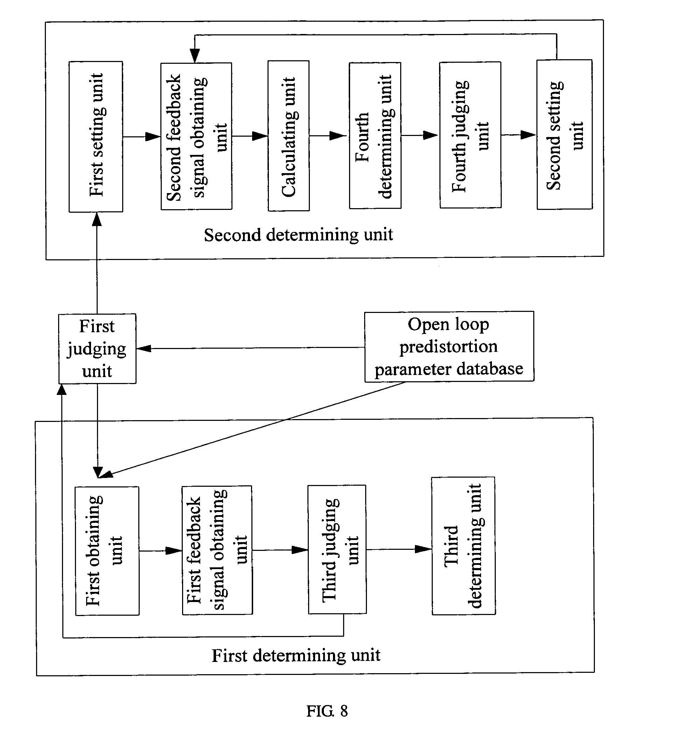

As shown in FIG. 8, an apparatus for obtaining open loop predistortion parameters is disclosed in this embodiment. The apparatus includes:
an open loop predistortion parameter database, configured to store open loop predistortion parameters;
a first judging unit, configured to: judge whether none of feedback signals corresponding to all open loop predistortion parameters in the open loop predistortion parameter database satisfies RF requirements; and start a second determining unit if none of the feedback signals satisfies the RF requirements, or start a first determining unit if any of the feedback signals satisfies the RF requirements;
the first determining unit, configured to determine candidate open loop predistortion parameters of a transmitter according to the open loop predistortion parameters in the open loop predistortion parameter database; and
the second determining unit, configured to determine candidate open loop predistortion parameters of the transmitter by using a training signal.

The first determining unit includes:
a first obtaining unit, configured to: obtain unselected open loop predistortion parameters in the open loop predistortion parameter database, use such parameters as test open loop predistortion parameters, and start a first feedback signal obtaining unit;
the first feedback signal obtaining unit, configured to: use the test open loop distortion parameters to obtain a feedback signal, and start a third judging unit;
the third judging unit, configured to: judge whether the feedback signal obtained by the first feedback signal obtaining unit satisfies RF requirements; start a third determining unit and terminate the process if the feedback signal satisfies the RF requirements, or start the first judging unit if the feedback signal does not satisfy the RF requirements; and
the third determining unit, configured to use the test open loop predistortion parameters as candidate open loop predistortion parameters of the transmitter.

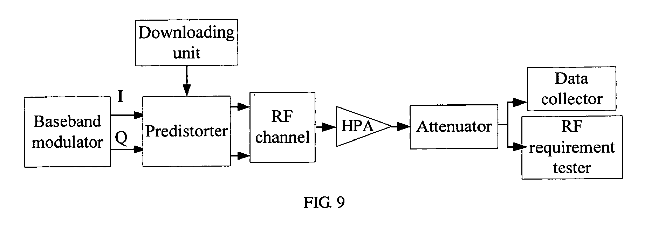

As shown in FIG. 9, the first feedback signal obtaining unit includes:
a baseband modulator, configured to generate a baseband signal;
a downloading unit, configured to download the test open loop predistortion parameters to a predistorter;
the predistorter, configured to: pre-distort a training signal sent by the baseband modulator, and output the pre-distorted training signal;
an RF channel, configured to perform RF processing for the pre-distorted training signal output by the predistorter, and output the signal after RF processing;
an HPA, configured to: amplify power of the signal output by the RF channel, and output the amplified signal;
an attenuator, configured to attenuate the signal output by the HPA, and output the attenuated signal;
a data collector, configured to collect the attenuated signal as a feedback signal; and
an RF requirement tester, configured to test whether a feedback signal satisfies the RF requirements.

The second determining unit includes:
a first setting unit, configured to: set bypass parameters as test open loop predistortion parameters, and start a second feedback signal obtaining unit;
the second feedback signal obtaining unit, configured to: use the test open loop distortion parameters to obtain a feedback signal, output the feedback signal, and start a calculating unit;
the calculating unit, configured to: calculate the open loop predistortion parameters according to a training signal and the feedback signal output by the second feedback signal obtaining unit, and start a fourth determining unit; and
the fourth determining unit, configured to determine the open loop predistortion parameters obtained by the calculating unit as candidate open loop predistortion parameters of the transmitter.

The second determining unit may include:
a fourth judging unit, configured to: judge whether the feedback signal corresponding to the open loop predistortion parameters obtained by the calculating unit satisfies RF requirements, and determine the open loop predistortion parameters as candidate open loop predistortion parameters of the transmitter and terminate the process if the feedback signal satisfies the RF requirements, or start a second setting unit if the feedback signal does not satisfy the RF requirements; and
the second setting unit, configured to: set the open loop predistortion parameters that do not satisfy the RF requirements as candidate open loop predistortion parameters, and start the second feedback signal obtaining unit.

As shown in FIG. 9, the second feedback signal obtaining unit includes:
a baseband modulator, configured to generate a baseband signal;
a downloading unit, configured to download the test open loop predistortion parameters to a predistorter;
the predistorter, configured to: pre-distort a training signal sent by the baseband modulator, and output the pre-distorted training signal;
an RF channel, configured to perform RF processing for the pre-distorted training signal output by the predistorter, and output the signal after RF processing;
an HPA, configured to: amplify power of the signal output by the RF channel, and output the amplified signal;
an attenuator, configured to attenuate the signal output by the HPA, and output the attenuated signal;
a data collector, configured to collect the attenuated signal as a feedback signal; and
an RF requirement tester, configured to test whether a feedback signal satisfies the RF requirements.

The calculating unit includes:
an aligning unit (not illustrated in FIG. 8), configured to align the feedback signal with the training signal, and output the aligned feedback signal and training signal;
a frequency deviation and phase deviation correcting unit (not illustrated in FIG. 8), configured to correct the frequency deviation and phase deviation of the feedback signal and training signal aligned by the aligning unit, and output the a corrected feedback signal and training signal;
an AQM correcting unit (not illustrated in FIG. 8, optional), configured to calculate AQM correction parameters for the feedback signal and training signal output by the frequency deviation and phase deviation correcting unit, where the AQM correcting unit is optional; and
a calculating subunit (not illustrated in FIG. 8), configured to calculate open loop predistortion parameters according to the feedback signal and training signal output by the frequency deviation and phase deviation correcting unit.

In the embodiments of the present invention, an open loop predistortion technology is applied to improve linearity of the transmitter, thus reducing the power back off of the HPA, improving the working efficiency, and reducing the operation cost. Moreover, no feedback channel or parameter correction calculation on the processor is required. Therefore, the embodiments of the present invention reduce the manufacturing cost.

Although the invention has been described through several exemplary embodiments, the invention is not limited to such embodiments. It is apparent that those skilled in the art can make modifications and variations to the invention without departing from the spirit and scope of the invention. The invention is intended to cover the modifications and variations provided that they fall within the scope of protection defined by the following claims or their equivalents.

## Claims

1. A method for determining open loop predistortion parameters, comprising:
selecting open loop predistortion parameters in an open loop predistortion parameter database as candidate open loop predistortion parameters of a transmitter; and
using a training signal to determine candidate open loop predistortion parameters of the transmitter if none of feedback signals corresponding to all open loop predistortion parameters in the open loop predistortion parameter database satisfies Radio Frequency, RF, requirements.

2. The method of claim 1, wherein the step of selecting the open loop predistortion parameters in the open loop predistortion parameter database as the candidate open loop predistortion parameters of the transmitter comprises:
selecting the open loop predistortion parameters in the open loop predistortion parameter database as test open loop predistortion parameters;
obtaining a feedback signal corresponding to the test open loop predistortion parameters; and
judging whether the feedback signal satisfies the RF requirements, and using the test open loop predistortion parameters as the candidate open loop predistortion parameters of the transmitter if the feedback signal satisfies the RF requirements.

3. The method of claim 1, wherein the step of selecting the open loop predistortion parameters in the open loop predistortion parameter database as the candidate open loop predistortion parameters of the transmitter comprises:
selecting the open loop predistortion parameters in the open loop predistortion parameter database as test open loop predistortion parameters;
obtaining a feedback signal corresponding to the test open loop predistortion parameters;
recording the test open loop predistortion parameters, and RF requirements corresponding to the test open loop predistortion parameters if the feedback signal satisfies the RF requirements;
obtaining unselected open loop predistortion parameters in the open loop predistortion parameter database, using the unselected open loop predistortion parameters as test open loop predistortion parameters, and repeating the step of obtaining a feedback signal corresponding to the test open loop predistortion parameters and the step of recording until all open loop predistortion parameters in the open loop predistortion parameter database are selected; and
among the recorded test open loop predistortion parameters, and the recorded RF requirements corresponding to the test open loop predistortion parameters, selecting test open loop predistortion parameters corresponding to preferred RF requirements as the candidate open loop predistortion parameters of the transmitter.

4. The method of claim 2 or claim 3, wherein the step of obtaining the feedback signal corresponding to the test open loop predistortion parameters comprises:
downloading the test open loop predistortion parameters to a predistorter;
pre-distorting, by the predistorter, a training signal sent by a baseband modulator, and passing the pre-distorted training signal through an RF channel and a High Power Amplifier, HPA, sequentially;
attenuating the signal output by the HPA; and
obtaining the attenuated signal output by the HPA as a feedback signal.

5. The method of claim 1, wherein the step of using a training signal to determine candidate open loop predistortion parameters of the transmitter comprises:
passing the training signal sent by a baseband modulator through an RF channel and a High Power Amplifier, HPA, sequentially;
attenuating the signal output by the HPA;
obtaining the attenuated signal output by the HPA as a feedback signal;
obtaining open loop predistortion parameters according to the training signal and the feedback signal; and
determining the obtained open loop predistortion parameters as the candidate open loop predistortion parameters of the transmitter.

6. The method of claim 5, wherein the step of obtaining open loop predistortion parameters according to the training signal and the feedback signal comprises:
obtaining test open loop predistortion parameters according to the training signal and the feedback signal; and
judging whether the feedback signal corresponding to the test open loop predistortion parameters satisfies the RF requirements; reserving the test open loop predistortion parameters if the feedback signal satisfies the RF requirements, or recalculating open loop predistortion parameters with the test open loop predistortion parameters if the feedback signal does not satisfy the RF requirements.

7. The method of claim 6, wherein the step of recalculating open loop predistortion parameters with the test open loop predistortion parameters comprises:
obtaining a feedback signal by using the test open loop predistortion parameters, and calculating new open loop predistortion parameters; and
judging whether the feedback signal satisfies the RF requirements; reserving the calculated new open loop predistortion parameters if the feedback signal satisfies the RF requirements, or using the calculated open loop predistortion parameters as test open loop predistortion parameters if the feedback signal does not satisfy the RF requirements and repeating the step of obtaining a feedback signal by using the test open loop predistortion parameters and calculating new open loop predistortion parameters, the step of judging whether the feedback signal satisfies the RF requirements, and the step of using the calculated open loop predistortion parameters as test open loop predistortion parameters until the feedback signal satisfies the RF requirements or a pre-set number of repeating is achieved.

8. The method of claim 7, wherein the step of obtaining a feedback signal by using the test open loop predistortion parameters and calculating new open loop predistortion parameters comprises:
downloading the test open loop predistortion parameters to a predistorter;
pre-distorting, by the predistorter, a training signal sent by a baseband modulatorsignal, and passing the pre-distorted training signal through the RF channel and the HPA sequentially;
attenuating the signal output by the HPA;
obtaining the attenuated signal output by the HPA as a feedback signal; and
obtaining new open loop predistortion parameters according to the training signal and the feedback signal.

9. The method of claim 8, wherein the step of obtaining new open loop predistortion parameters according to the training signal and the feedback signal comprises:
aligning the feedback signal with the training signal;
correcting frequency deviation and phase deviation of the feedback signal and the training signal; and
calculating new open loop predistortion parameters according to the corrected feedback signal and training signal.

10. An apparatus for obtaining open loop predistortion parameters, comprising:
an open loop predistortion parameter database, configured to store open loop predistortion parameters;
a first judging unit, configured to: judge whether none of feedback signals corresponding to all open loop predistortion parameters in the open loop predistortion parameter database satisfies Radio Frequency, RF, requirements; and start a second determining unit if none of the feedback signals satisfies the RF requirements, or start a first determining unit if any of the feedback signals satisfies the RF requirements;
the first determining unit, configured to determine candidate open loop predistortion parameters of a transmitter according to the open loop predistortion parameters in the open loop predistortion parameter database; and
the second determining unit, configured to determine candidate open loop predistortion parameters of the transmitter by using a training signal.

11. The apparatus of claim 10, wherein the first determining unit comprises:
a first obtaining unit, configured to: obtain unselected open loop predistortion parameters in the open loop predistortion parameter database, use the unselected open loop predistortion parameters as test open loop predistortion parameters, and start a first feedback signal obtaining unit;
the first feedback signal obtaining unit, configured to: obtain a feedback signal by using the test open loop distortion parameters, and start a third judging unit;
the third judging unit, configured to: judge whether the feedback signal obtained by the first feedback signal obtaining unit satisfies the RF requirements; start a third determining unit if the feedback signal obtained by the first feedback signal obtaining unit satisfies the RF requirements, or start the first judging unit if the feedback signal obtained by the first feedback signal obtaining unit does not satisfy the RF requirements; and
the third determining unit, configured to use the test open loop predistortion parameters as the candidate open loop predistortion parameters of the transmitter.

12. The apparatus of claim 11, wherein the first feedback signal obtaining unit comprises:
a baseband modulator, configured to generate a baseband signal;
a downloading unit, configured to download the test open loop predistortion parameters to a predistorter;
the predistorter, configured to: pre-distort a training signal sent by the baseband modulator, and output the predistorted training signal;
an RF channel, configured to perform RF processing for the signal output by the predistorter, and output the processed signal;
a High Power Amplifier, HPA, configured to: amplify power of the signal processed by the RF channel, and output the amplified signal;
an attenuator, configured to attenuate the signal output by the HPA, and output the attenuated signal;
a data collector, configured to collect the attenuated signal as a feedback signal; and
an RF requirement tester, configured to test whether a feedback signal satisfies the RF requirements.

13. The apparatus of claim 10, wherein the second determining unit comprises:
a first setting unit, configured to: set bypass parameters as test open loop predistortion parameters, and start a second feedback signal obtaining unit;
the second feedback signal obtaining unit, configured to: obtain a feedback signal by using the test open loop distortion parameters, output the obtained feedback signal, and start a calculating unit;
the calculating unit, configured to: calculate open loop predistortion parameters according to a training signal and the feedback signal output by the second feedback signal obtaining unit, and start a fourth determining unit; and
the fourth determining unit, configured to determine the open loop predistortion parameters calculated by the calculating unit as the candidate open loop predistortion parameters of the transmitter.

14. The apparatus of claim 13, wherein the second feedback signal obtaining unit comprises:
a baseband modulator, configured to generate a baseband signal;
a downloading unit, configured to download the test open loop predistortion parameters to a predistorter;
the predistorter, configured to: pre-distort the training signal sent by the baseband modulator, and output the pre-distorted training signal;
an RF channel, configured to perform RF processing for the signal output by the predistorter, and output the processed signal;
a High Power Amplifier, HPA, configured to: amplify power of the signal output by the RF channel, and output the amplified signal;
an attenuator, configured to attenuate the signal output by the HPA, and output the attenuated signal;
a data collector, configured to collect the attenuated signal as a feedback signal; and
an RF requirement tester, configured to test whether a feedback signal satisfies the RF requirements.

15. The apparatus of claim 13, wherein the second determining unit further comprises:
a fourth judging unit, configured to: judge whether the feedback signal corresponding to the open loop predistortion parameters calculated by the calculating unit satisfies the RF requirements, and determine the open loop predistortion parameters as the candidate open loop predistortion parameters of the transmitter if the feedback signal calculated by the calculating unit satisfies the RF requirements, or start a second setting unit if the feedback signal calculated by the calculating unit does not satisfy the RF requirements; and
a second setting unit, configured to: set the open loop predistortion parameters as test open loop predistortion parameters, and start the second feedback signal obtaining unit.

16. The apparatus of any of claims 13-15, wherein the calculating unit comprises:
an aligning unit, configured to align the feedback signal with the training signal, and output the aligned signal;
a frequency deviation and phase deviation correcting unit, configured to correct frequency deviation and phase deviation of the feedback signal and the training signal output by the aligning unit, and output the corrected signal; and
a calculating subunit, configured to calculate open loop predistortion signal according to the feedback signal and the training signal output by the frequency deviation and phase deviation correcting unit.

17. A transmitter, comprising:
a predistorter, configured to: receive a baseband signal from a baseband modulator, pre-distort the baseband signal by using open loop predistortion parameters, and send the pre-distorted signal to a downstream component, wherein the open loop predistortion parameters are pre-set in the predistorter.

18. The transmitter of claim 17, wherein:
the transmitter is a zero Intermediate Frequency, IF, transmitter or a digital IF transmitter.

19. A transmitting method, comprising:
receiving a baseband signal output by a baseband modulator; and
pre-distorting the baseband signal by using open loop predistortion parameters, and sending the pre-distorted signal to a downstream component, wherein the open loop predistortion parameters are pre-set in a predistorter.

20. The transmitting method of claim 19, wherein the open loop predistortion parameters are determined through the following steps:
using open loop predistortion parameters in an open loop predistortion parameter database to determine the open loop predistortion parameters of a transmitter; and
using a training signal to determine the open loop predistortion parameters of the transmitter if none of feedback signals corresponding to all open loop predistortion parameters in the open loop predistortion parameter database satisfies Radio Frequency, RF, requirements.
